# EUROPÄISCHE PATENTSCHRIFT

(11) **EP 2 651 549 B1**
(45) Veröffentlichungstag und Bekanntmachung des Hinweises auf die Patenterteilung: **31.07.2019**
(21) Anmeldenummer: 11802038.7
(22) Anmeldetag: 14.12.2011
(51) Int. Cl.: B01J 19/00, B81C 1/00, F28F 3/04, F28D 9/00

(54) **MIKROFLUIDISCHES BAUTEIL, REAKTOR AUS MEHREREN SOLCHEN BAUTEILEN UND VERFAHREN ZU DEREN HERSTELLUNG**
MICROFLUIDIC COMPONENT, REACTOR COMPRISING A PLURALITY OF SUCH COMPONENTS, AND METHOD FOR PRODUCING SAME
ÉLÉMENT MICROFLUIDIQUE, RÉACTEUR CONSTITUÉ DE PLUSIEURS ÉLÉMENTS DE CE TYPE ET PROCÉDÉ DE FABRICATION ASSOCIÉ

(30) Priorität: 14.12.2010 DE 102010063074
(43) Veröffentlichungstag der Anmeldung: 23.10.2013
(73) Patentinhaber: Fraunhofer-Gesellschaft zur Förderung der angewandten Forschung e.V., 80686 München (DE)
(72) Erfinder: WICHERT, Martin, 65307 Bad Schwalbach (DE); KRAUS, Silvio, 99734 Nordhausen (DE)
(74) Vertreter: Mehler Achler
(86) Internationale Anmeldenummer: PCT/EP2011/072724
(87) Internationale Veröffentlichungsnummer: WO 2012/080313

(56) Entgegenhaltungen:
- EP-A1- 0 866 301
- WO-A1-2005/088223
- DE-A1- 19 809 140
- DE-A1-102007 006 578
- DE-B3- 10 357 082
- DE-T2- 69 532 051
- US-A- 4 777 560
- US-A1- 2007 240 473
- US-B1- 6 263 715

## Beschreibung

Die Erfindung betrifft ein mikrofluidisches Bauteil aus einem Blech, das derart gefaltet ist, dass Fluidleitungen gebildet werden. Als "mikrofluidisches Bauteil" oder Bauteil mit einer mikrofluidischen Struktur wird im Sinne dieser Schrift beispielsweise ein Bauteil eines modular aufgebauten Mikroreaktors, Mikrowärmetauschers, Mikromischers oder dergleichen verstanden, bei dem eine in die Oberfläche des Bauteils eingebrachte Mikrostruktur, wie beispielsweise Kanäle, Taschen oder sonstige Vertiefungen, allgemein als Fluidleitungen bezeichnet, Abmessungen im Nanometerbereich bis Millimeterbereich, insbesondere laterale Abmessungen von 100 nm bis 1 mm, aufweisen. Mit laterale Abmessung ist zumindest eine Abmessung quer zur wesentlichen Fließrichtung gemeint. Vorstehende Angaben beziehen sich im Fall breiter Strukturen wie Taschen auf deren kleinste Abmessung, also deren Profiltiefe . Etwaige Bohrungen durch das Blech werden im Sinne dieser Definition nicht zu der Oberflächenstruktur gerechnet.

"Fluidleitung" im Sinne dieser Schrift wird als Oberbegriff für alle Kavitäten beliebiger geometrischer Form zur Aufnahme und/oder Leitung eines Fluids verwendet. Beispiele sind Taschen, Kanäle, Röhren oder dergleichen. Es wird unterschieden zwischen offenen und geschlossenen Fluidleitungen. Als "offene Fluidleitung" werden hierin solche Fluidleitungen bezeichnet, die abgesehen von etwaigen Zu- und/oder Abläufen zumindest einseitig offen sind. Im Gegensatz hierzu ist hierin mit einer "geschlossenen Fluidleitung" eine bis auf etwaige Zu- und/oder Abläufe durch Wandabschnitte allseitig begrenzte Kavität gemeint.

Eine mikrofluidische Struktur und ein Verfahren zu deren Herstellung ist beispielsweise in der Schrift DE 101 08 469 B4 beschrieben. Mit dem dort offenbarten Prägeverfahren lassen sich unterschiedliche, offene Strukturelemente in die Oberfläche des Bleches einprägen. Das Ergebnis sind so immer mikrofluidische Bauteile mit offenen Fluidleitungen. Im Sinne vorstehender Definitionen ist das gemäß dieser Lehre gefertigte mikrofluidische Bauteil also nicht unter dem Oberbegriff des Patentgegenstands gemäß Anspruch 1 zu subsummieren, da es keine geschlossene Fluidleitung aufweist.

Eine geschlossene Fluidleitung sowie deren Herstellung ist beispielsweise aus der DE 196 43 934 A1 bekannt. Das Ergebnis des Herstellungsverfahrens ist ein Metallblechverbund aus zwei zusammengeführten und gemeinsam eine Kalibriereinheit durchlaufenden Metallblechen, von denen eines zuvor mittels zweier in kämmendem Eingriff stehender Profilwalzen ein Wellenprofil aufgeprägt bekommt. Mehrere solcher Metallblechverbunde werden anschließend aufeinandergestapelt, sodass sich das Blech mit Wellenprofil und das glatte Blech immer abwechseln, aufgewickelt und als Wabenkörper in ein Mantelrohr eingesetzt, um beispielsweise als katalytischer Konverter in Abgasanlagen von Kraftfahrzeugen zu dienen. Zwar behandelt die Schrift die Herstellung strukturierter Metallbleche, die offenkundig nicht zu den mikrofluidischen Bauteilen zu rechnen sind. Aber das das dort beschriebene Verfahren lässt sich grundsätzlich auch auf mikrofluidische Bauteile übertragen. Das Verfahren eignet sich jedoch fast ausschließlich zur Herstellung eben solcher Wabenkörper. Andere, komplexere Strukturen lassen sich durch das dort beschriebene Herstellungsverfahren nicht herstellen.

Ein sehr ähnlicher Aufbau eines Reaktors für eine katalytische Reaktion ist aus der Schrift EP 0 885 653 A2 bekannt. Der Reaktor ist stapelförmig aus einer mäanderförmig gefalteten Trennwand und in die gebildeten Falten eingelegten wellenförmigen Blechelemente aufgebaut. Die Strukturenvielfalt beschränkt sich auch hierbei lediglich auf unterschiedliche Querschnittsformen des Wellenprofils.

Sollten darüber hinaus insbesondere quer zu der Wellenstruktur angeordnete Strukturelemente zur Verteilung des Fluids (Verteilerkanäle) oder sonstige Fluidleitungen vorgesehen sein, ist nicht ersichtlich, wie diese auf einfache Weise ausgestaltet werden könnten.

Aus der WO 2005/088223 A1 ist ein Wärmetauscher bekannt, der aus einer Vielzahl aufeinander gestapelter und miteinander verbundener, insbesondere verlöteter, länglicher Scheiben zusammengesetzt sind. Die Scheiben bestehen wiederrum aus zwei Scheibenhälften, die entlang einer Biegekante dergestalt gefaltet sind, dass die beiden Hälftenflächen parallel aufeinanderliegen und einen Hohlraum in Form einer Vielzahl von Rillen zum Durchführen eines zu kühlenden Mediums umschließen.

Aus der DE 10357082 B3 ist ein spiralförmiger Wärmetauscher mit einem Führungsbauteil aus einem rechteckigen, hälftig um eine Faltungslinie gefalteten und anschließend um die Faltungslinie zusammengerollten Folienelement bekannt. Das Folienelement ist entlang der Faltungslinie in zwei Hälften unterteilt, wobei die eine Hälfte auf einer Flächenseite und die andere Hälfte auf der gegenüberliegenden Flächenseite Vertiefungen aufweisen, welche sich als Fluidführungen von der Faltungslinie bis zum gegenüber der Faltungslinie gelegenen Rand des Folienelements erstrecken.

DE 10 2007 006 578 A1 offenbart ein Bauteil, das durch Falten eines Bleches mit einem eine wellenförmig strukturierte Oberfläche aufweisenden ersten und einem eine unstrukturierte Oberfläche aufweisenden zweiten Abschnitt und einem eine konturierte Kante aufweisenden dritten Abschnitt, hergestellt wird.

Neben den aus den zitierten Schriften bekannten Verfahren sind eine Vielzahl von materialabtragenden Verfahren zur Herstellung mikrofluidischer Strukturen bekannt. Sie basieren auf elektrischen, chemischen, elektrochemischen oder mechanischen materialabtragenden Prozessen. Diese Verfahren haben jedoch gemeinsam zum Nachteil, dass die Bearbeitung vergleichsweise viel Zeit in Anspruch nimmt und deshalb eine kostengünstige Massenherstellung so nicht möglich erscheint.

Vor diesem Hintergrund ist die Aufgabe der vorliegenden Erfindung, ein einfaches mikrofluidisches Bauteil mit einer größeren Vielfalt an Strukturmerkmalen, einen mikrofluidischer Reaktor mit mehreren solcher Bauteile und ein kostengünstiges Verfahren zu deren Herstellung bereitzustellen.

Die Aufgabe wird einerseits gelöst durch ein mikrofiuidisches Bauteil gemäß Anspruch 1, durch einen mikrofluidischen Reaktor mit den Merkmalen des Patentanspruches 7 sowie durch die Verfahren gemäß Anspruch 9. Vorteilhafte Weiterbildungen sind Gegenstand der Unteransprüche.

Gemäß einem Aspekt der Erfindung kann das mikrofluidische Bauteil aus einem Blech mit einer eine geschlossene Fluidleitung umfassenden Struktur dadurch gekennzeichnet, dass die geschlossene Fluidleitung aus einer strukturierten Oberfläche eines ersten Abschnitts des Bleches und einer angrenzenden unstrukturierten Oberfläche eines zweiten Abschnitts des Bleches gebildet wird, wobei das Blech derart gefaltet ist, dass die einstückig zusammenhängenden Abschnitte flächenparallel aufeinanderliegen.

Als "Blechabschnitt" wird hierin ein Teil eines einstückig zusammenhängenden Bleches verstanden. Der Begriff "Oberfläche" im Sinne der Schrift ist eine Fläche auf der Ober- oder Unterseite des jeweiligen Blechabschnittes. Als "unstrukturierte Oberfläche" wird eine Oberfläche ohne funktionale Strukturierung verstanden. Herstellungsbedingte Strukturen des Rohlings, wie beispielsweise die Rauheit eines gebürsteten, geschliffenen oder gewalzten Bleches oder dergleichen, sind keine solche funktionale Strukturierung. Entsprechende Oberflächen werden deshalb als unstrukturiert bezeichnet. Dementgegen wird hierin als "strukturierte Oberfläche" eine Oberfläche mit einer mikrofluidisch funktionalen, gezielt eingebrachten Oberflächenstruktur wie beispielsweise Fluidleitungen verstanden.

Das korrespondierende Verfahren zur Herstellung eines mikrofluidischen Bauteils sieht vor, ein Blech mit wenigstens einem eine strukturierte Oberfläche aufweisenden ersten Abschnitt und wenigstens einem eine strukturierte Oberfläche aufweisenden zweiten Abschnitt derart zu falten, dass der erste Abschnitt flächenparallel auf dem zweiten Abschnitt zu liegen kommt und die strukturierte Oberfläche des ersten Abschnitts zusammen mit der dann angrenzenden strukturierten oder unstrukturierten Oberfläche des zweiten Abschnitts eine geschlossene Fluidleitung bilden.

Entgegen dem bekannten Stand der Technik wird das mikrofluidische Bauteil aus zwei flächenparallel aufeinanderliegenden, einstückig zusammenhängenden Blechabschnitten umgeformt, indem das Blech entlang einer Biegekante auf einfache Weise gefaltet wird. Im Ergebnis kann man so ein komplexeres Bauteil mit einer oder mehreren geschlossenen Fluidleitungen auf einfache Weise erzeugen. Vorteilhaft ist auch, dass das mikrofluidische Bauteil aufgrund der Einstückigkeit leichter weiter zu verarbeiten ist, beispielsweise zu einem mikrofluidischen Reaktor.

Vorteilhaft ist es, wenn in dem Verfahren die strukturierte Oberfläche in einem dem Falten vorgeschalteten Prägeschritt hergestellt wird. Die strukturierte Oberfläche wird durch Prägen einer wellenförmigen Struktur hergestellt.

Auf beide vorbeschriebenen Weisen wird, im Grunde durch Einsatz von an sich bekannten Methoden der Präge- und Umformtechnik, ein kostengünstiges mikrofluidisches Bauteil hergestellt, mit welchem sich eine Vielzahl von Strukturen, insbesondere offenen und geschlossene Fluidleitungen realisieren lassen.

Der Begriff "Prägen" wird hierin als Oberbegriff für alle Umformverfahren verwendet, mit denen sich ein Blech mit einer Oberflächenstruktur versehen lässt. Dies kann im Sinne des Einprägens (Druckumformen) ein Erzeugen von Vertiefungen auf nur einer Seite des Bleches sein, während die gegenüberliegende Oberfläche glatt bleibt oder eine andere Struktur erhält. Dazu soll auch das Tiefziehen, eine Kombination von Streck- und Tiefziehen (Zugdruckumformen) des Bleches zwischen einem Stempel und einer Matrize oder das Biegen des Bleches beispielsweise zwischen zwei kämmenden Profilwalzen zählen, bei dem das Blech jeweils vorder- und rückseitig komplementäre Strukturen erhält. Allgemein wird hierin vereinfachend von einer "geprägten Oberfläche" gesprochen.

Gemäß der vorliegenden Erfindung weist das mikrofluidische Bauteil ein Blech mit wenigstens einem eine wellenförmig strukturierte Oberfläche aufweisenden ersten und wahlweise einem eine wellenförmig strukturierte oder unstrukturierte Oberfläche aufweisenden zweiten Abschnitt und wenigstens einem eine konturierte Kante aufweisenden dritten Abschnitt auf, das derart gefaltet ist, dass die einstückig zusammenhängenden ersten und dritten Abschnitte flächenparallel aufeinander liegen und die konturierte Kante einen ersten Wandabschnitt und die angrenzende wellenförmig strukturierte Oberfläche einen zweiten Wandabschnitt einer offenen Fluidleitung bilden, wobei als offenen Fluidleitung eine Fluidleitung verstanden wird, die abgesehen von etwaigen Zu- und/oder Abläufen zumindest einseitig offen ist und wobei die Profiltiefe der offenen Fluidleitung gleich der Blechstärke des Bleches ist.

Das erfindungsgemäße, hiermit korrespondierende Verfahren zur Herstellung eines mikrofluidischen Bauteils sieht vor, ein Blech mit wenigstens einem eine wellenförmig strukturierte Oberfläche aufweisenden ersten und wahlweise einem eine wellenförmig strukturierte oder unstrukturierte Oberfläche aufweisenden zweiten Abschnitt und wenigstens einem eine konturierte Kante aufweisenden dritten Abschnitt derart zu falten, dass der dritte Abschnitt mit der konturierten Kante flächenparallel auf dem ersten Abschnitt mit der wellenförmig strukturierte Oberfläche zu liegen kommt und die konturierte Kante einen ersten Wandabschnitt und die nach dem Falten daran angrenzende wellenförmig strukturierte Oberfläche einen zweiten Wandabschnitt einer offenen Fluidleitung bilden, wobei als offenen Fluidleitung eine Fluidleitung verstanden wird, die abgesehen von etwaigen Zu- und/oder Abläufen zumindest einseitig offen ist und wobei die Profiltiefe der offenen Fluidleitung gleich der Blechstärke des Bleches ist.

Der Begriff "Kante" ist im Sinne dieser Schrift als Fläche entlang des Blechrandes zu verstehen, die im Allgemeinen senkrecht zu der Hauptebene des Bleches steht und beispielsweise beim Ausstanzen des Belches erzeugt wird. Als "Blechrand" ist dabei die Umrandung des senkrecht zu dessen Hauptebene projizierten Bleches zu verstehen. Eine "konturierte Kante" im Sinne dieser Schrift kann im einfachsten Fall eine gerade Kante sein. Die konturierte Kante folgt im allgemeinen einer beliebigen, funktional erforderlichen oder gewünschten Kurve. Die Begriffe "Wand" bzw. "Wandabschnitt" bezeichnen hierin ein räumliches Begrenzungselement einer Fluidleitung. Umgekehrt wird die Fluidleitung in der Regel durch mehrere Wandabschnitte definiert.

Bevorzugt wird die konturierte Kante in einem dem Falten vorgeschalteten Stanzschritt hergestellt.

Auf diese Weise wird durch den Einsatz von Präge- und Umformtechnik, kombiniert mit Stanztechnik, ein kostengünstiges mikrofluidisches Bauteil hergestellt, mit welchem sich eine Vielzahl von Strukturen, hierbei insbesondere offenen Fluidleitungen realisieren lassen.

Gemäß einer besonders bevorzugten Variante der Erfindung vereint das mikrofluidische Bauteil beide vorgenannten Aspekte. Hiernach wird die geschlossene Fluidleitung aus einer wellenförmig strukturierten Oberfläche eines ersten Abschnitts des Bleches und einer angrenzenden unstrukturierten Oberfläche eines zweiten Abschnitts des Bleches, wie vorstehend beschrieben, gebildet, wobei das Blech ferner wenigstens einen dritten Abschnitt mit einer konturierten Kante aufweist und derart gefaltet ist, dass die einstückig zusammenhängenden ersten und dritten Abschnitte flächenparallel aufeinanderliegen und die konturierte Kante des dritten Abschnitts einen ersten Wandabschnitt und die angrenzende wellenförmig strukturierte Oberfläche des ersten Abschnitts einen zweiten Wandabschnitt einer offenen Fluidleitung bilden.

Das korrespondierende erfindungsgemäße Verfahren sieht vor, ein Blech mit wenigstens einem eine wellenförmig strukturierte Oberfläche aufweisenden ersten Abschnitt und wenigstens einem eine unstrukturierte Oberfläche aufweisenden zweiten Abschnitt wie vorstehend beschrieben zu falten, wobei das Blech einen eine konturierte Kante aufweisenden dritten Abschnitt aufweist und ferner derart gefaltet wird, dass der dritte Abschnitt mit der konturierten Kante flächenparallel auf dem ersten Abschnitt mit der wellenförmig strukturierten Oberfläche zu liegen kommt und die konturierte Kante einen ersten Wandabschnitt und die nach dem Falten daran angrenzende strukturierte Oberfläche einen zweiten Wandabschnitt einer offenen Fluidleitung bilden.

Die Vereinigung der Vorteile beider Aspekte ermöglicht die Herstellung einer noch größeren Vielfalt an Strukturelementen. Ganz besonders bevorzugt erfolgt das Falten des Blechs derart, dass die geschlossene Fluidleitung einen geschlossenen Kanal bildet, der in die offene Fluidleitung mündet.

Eine konkrete Ausgestaltung eines entsprechend gefalteten mikrofluidischen Bauteils ist dadurch gekennzeichnet, dass die offene Fluidleitung eine Sammel- oder Verteilerstruktur zum Zusammenführen eines Fluids aus mehreren geschlossenen Kanälen bzw. Verteilen des Fluids auf mehrere geschlossene Kanäle ist. Unter Sammelstruktur wird eine meist zunächst breite und in Fließrichtung enger werdende Struktur verstanden, in die mehrere geschlossene Kanäle münden und in der das Fluid aus diesen Kanälen zusammengeführt und an eine oder mehreren Ableitungen abgegeben wird. Analog wird unter Verteilerstruktur eine in Fließrichtung meist breiter werdende Struktur verstanden, in die eine oder mehrere Zuleitungen münden und von der das Fluid aus diesen Zuleitungen auf die mehreren geschlossenen Kanäle verteilt wird. Verteiler- und Sammelstruktur unterscheiden sich insofern in erster Linie in ihrer Funktion, bedingt durch die Anströmrichtung des Fluids. Strukturell können sie identisch sein.

Der Begriff "Kanal" wird hierin zur Beschreibung einer langgestreckten, meist kapillaren Fluidleitung verwendet. Unter "geschlossener Kanal" wird daher eine bis auf eine ein- und/oder austrittsseitige Öffnung umfänglich begrenzte, röhrenförmige Fluidleitung verstanden. "Offener Kanal" beschreibt dementsprechend eine auf den Umfang bezogen zumindest einseitig offene, rillenförmige Fluidleitung.

Das vorstehend beschriebene mikrofluidische Bauteil lässt sich besonders kostengünstig und effizient nach einem Verfahren herstellen, bei dem das Stanzen, Prägen und Falten nacheinander in einem Folgeverbundwerkzeug erfolgt. Dies erlaubt sogar eine Massenproduktion.

Das mikrofluidische Bauteil ist im Hinblick auf eine Reaktoranwendung dahingehend weitergebildet, dass die strukturierte Oberfläche des ersten Abschnitts und/oder die strukturierte oder unstrukturierte Oberfläche des zweiten Abschnitts wenigstens im Bereich der geschlossenen und/oder offenen Fluidleitung beschichtet ist. Bevorzugt sind jedoch nur die strukturierten Oberflächen beschichtet, da auf den unstrukturierten Oberflächen der Katalysator meist schlechter haftet und in Bereichen unstrukturierter Oberflächen überdies keine exo- oder endothermen chemischen Reaktionen stattfinden sollten.

Entsprechend ist das erfindungsgemäße Verfahren dahingehend vorteilhaft weitergebildet, dass die strukturierte Oberfläche des ersten Abschnitts und/oder die strukturierte oder unstrukturierte Oberfläche des zweiten Abschnitts wenigstens im Bereich der geschlossenen und/oder offenen Fluidleitung beschichtet wird.

Der Beschichtungsprozess kann je nach Beständigkeit der aufzutragenden Schicht und Komplexität des Bauteils am Rohling, nach der Strukturierung der Oberfläche oder am fertig umgeformten mikrofluidischen Bauteil erfolgen. Bevorzugt wird die Oberfläche im Siebdruckverfahren beschichtet.

Ein weiterer Aspekt der vorliegenden Erfindung betrifft einen mikrofluidischen Reaktor aus mehreren mikrofluidischen Bauteilen der vorstehend beschriebenen Art, welche gestapelt und entlang ihres Umfangs bis auf gezielte Öffnungen fluiddicht verbunden sind. Hergestellt wird dieser mikrofluidische Reaktor in einem Verfahren, bei dem mehrere mikrofluidische Bauteile der vorstehend beschriebenen Art nach dem Falten übereinandergeschichtet und entlang ihres Umfangs bis auf gezielte Öffnungen fluiddicht verbunden werden.

Als mikrofluidischer Reaktor sind hierin Mikroreaktoren für chemische oder biochemische Prozesse, Mikrowärmetauscher oder auch Mikromischers zusam mengefasst.

Als Verbindung kommt eine Lötverbindung, vorzugsweise jedoch eine Schweißverbindung in Betracht, wenn eine Lötverbindung beispielsweise mit einem Katalysatormaterial in Konflikt steht. Die mehreren mikrofluidischen Bauteile werden besonders bevorzugt laserverschweißt.

In einem entsprechenden mikrofluidischen Reaktor grenzt vorzugsweise von den mehreren mikrofluidischen Bauteilen wenigstens eines mit einer offenen Fluidleitung im vorstehenden Sinne an ein benachbartes mikrofluidisches Bauteil der Gestalt an, dass die offene Fluidleitung und die strukturierte oder unstrukturierte Oberfläche eines ersten oder zweiten Abschnitts des benachbarten Bauteils eine geschlossene Fluidleitung bilden.

Mit anderen Worten wird erst beim Zusammensetzen der mikrofluidischen Bauteile zu einem Stapelreaktor die gewünschte mikrofluidische Gesamtstruktur vollständig ausgebildet.

Für die mikrofluidischen Bauteile im allgemeinen und für solche zur Anwendung in mikrofluidischer Reaktoren werden dünn ausgewalzte Bleche mit Materialstärken zwischen typischerweise 0,1 mm und 1 mm bevorzugt. Je nachdem, ob es sich um eine eingeprägte Oberflächenstruktur oder eine wellenförmig gezogene bzw. gebogene Oberflächenstrukturierung handelt, sind dickere bzw. dünnere Materialstärken vorteilhaft. Für Bleche mit wellenförmig strukturierten Abschnitten haben sich Blechstärken zwischen 0,1 mm und 0,5 mm und besonders bevorzugt zwischen 0,1 mm und 0,3 mm bewährt.

Die Breite der gebildeten offenen oder geschlossenen Fluidleitungen kann je nach Anwendung variieren. Im Fall von offenen oder geschlossenen Kanälen liegt die Breite und Tiefe vorzugsweise im Bereich von 100 nm bis 1 mm, besonders bevorzugt zwischen 25 µm und 1 mm. Im Fall von breiten oder taschenförmigen Strukturen, wie beispielsweise den Verteilerstrukturen, liegt zumindest die Strukturtiefe in den angegebenen Bereichen.

Weitere Merkmale und Vorteile der vorliegenden Erfindung werden nachfolgend anhand von Ausführungsbeispielen mit Hilfe der Zeichnungen näher erläutert. Es zeigen:
- Figuren 1A bis 1F: die Herstellung des erfindungsgemäßen mikrofluidischen Bauteils in sechs Einzelschritten;
- Figuren 2 bis 5: Querschnitte verschiedener Ausführungsformen des mikrofluidischen Bauteils nach dem Falten;
- Figur 6: eine Explosionszeichnung eines mikrofluidischen Reaktors, bestehend aus verschiedenen mikrofluidischen Bauteilen;
- Figur 7: einen Querschnitt durch einen Stapel geschichteter mikrofluidischer Bauteile gemäß einer ersten Ausführungsform;
- Figur 8: einen Querschnitt durch einen Stapel geschichteter mikrofluidischer Bauteile gemäß einer zweiten Ausführungsform; und
- Figur 9: einen Querschnitt durch einen Stapel geschichteter mikrofluidischer Bauteile gemäß einer dritten Ausführungsform.

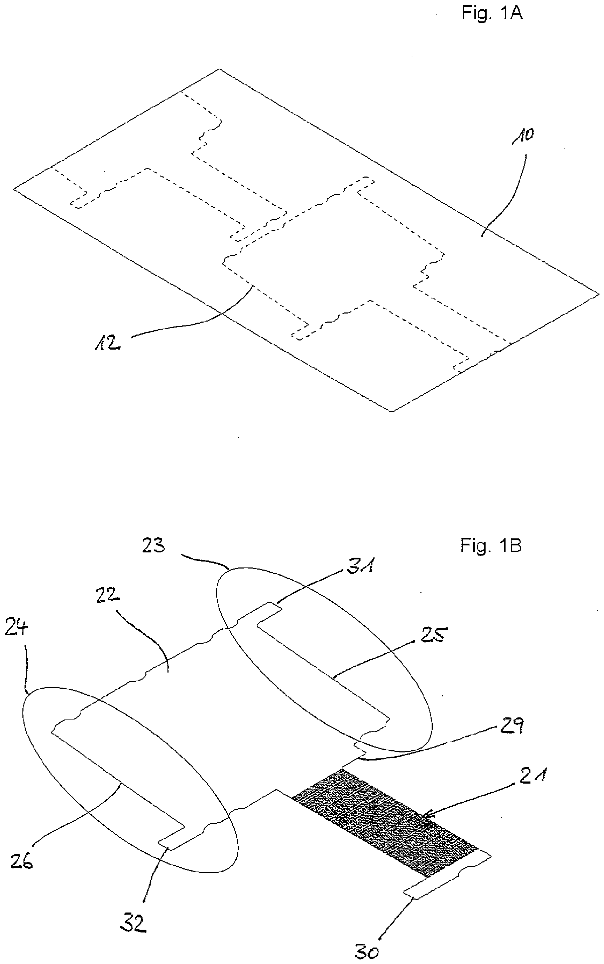

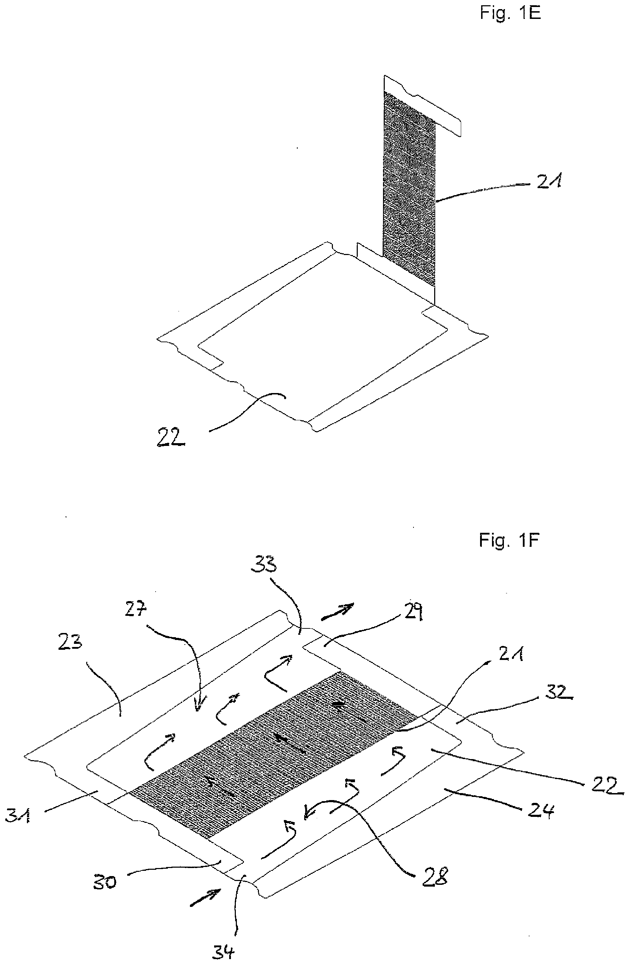

Die Figuren 1A bis 1F zeigen der Reihe nach eine Platine, einen Rohling, Zwischenerzeugnisse und das Endprodukt eines nach dem erfindungsgemäßen Verfahren hergestellten mikrofluidischen Bauteils.

Figur 1A zeigt einen Ausschnitt eines Blechstreifens 10, vorzugsweise eines Edelstahlbleches, aus welchem entlang der gestrichelten Konturlinie 12 Rohlinge mit definierter Außengeometrie für die Herstellung des mikrofluidischen Bauteils abgeteilt werden. "Abteilen" sei hier als Oberbegriff für verschieden Trennverfahren wie Stanzen, Sägen, Schneiden, Laserschneiden oder Scheren verstanden, von denen das Stanzen als bevorzugt gilt. Der Blechstreifen kann beispielsweise in Form eines langen Bandes, quasi kontinuierlich von einem so genannten "Coil" abgewickelt werden.

Anstelle des Blechstreifens wie in Figur 1A skizziert, können mehrere Rohlinge auch aus einem breiteren Blech oder einzelne Rohlinge aus jeweils einer separaten Platine ausgestanzt werden. Die Wahl der Ausgangsform des Materials wird sich nach der Marge, der Verfügbarkeit von Maschinen/Automaten, der geforderten Außengeometrie des Rohlings und der damit verbundenen Optimierung des Schnittmusters (Abfallminimierung), kurz nach der Wirtschaftlichkeit des Herstellungsverfahrens richten.

Bedingungen an den Werkstoff als solchen sind die fluiddichte Löt- bzw. Schweißbarkeit, insbesondere mittels Laserschweißen, gute Haftung des Katalysatormaterials sowie die thermische Beständigkeit für die Reaktionstemperaturen.

Das Ausstanzen des Rohlings ist nicht zwingend Bestandteil des erfindungsgemäßen Herstellungsverfahrens, wenn beispielsweise der vorgefertigte Rohling das Ausgangsmaterial bildet. Bei Verwendung eines Folgeverbundwerkzeuges, in dem das Ausstanzen Prozessschritt integriert ist, kann es aber auch dem erfindungsgemäßen Herstellungsverfahren zuzurechnen sein. Das Ausstanzen selbst kann wiederum in mehreren Schritten erfolgen. Das Ausstanzen und das Prägen können in beliebiger Reihenfolge erfolgen.

Ausgehend von dem auf die ein oder andere Weise erzeugten Rohling, kommt man zu dem in Figur 1B dargestellten Zwischenerzeugnis, das sich funktional in einen ersten Abschnitt 21 mit strukturierter Oberfläche, einen daran angrenzenden zweiten Abschnitt 22 mit unstrukturierter Oberfläche und zwei dritte Abschnitte 23 und 24 mit jeweils einer konturierten Außenkante 25 bzw. 26 unterteilt. Die strukturierte Oberfläche des ersten Abschnitts 21 weist offene Mikrokanäle senkrecht zur Längsrichtung des Abschnitts 21 auf.

Die Mikrokanäle können in einem dem Abteilen folgenden Arbeitsschritt einseitig in den Blechabschnitt eingeprägt oder durch eines der bekannten chemischen, elektrischen, elektrochemischen oder mechanischen materialabtragenden Verfahren eingebracht worden sein. Obgleich die letztgenannten Verfahren für eine Massenproduktion weniger in Frage kommen, soll die vorliegende Erfindung einen entsprechenden Bearbeitungsschritt nicht ausschließen. Selbstverständlich sind Prägeverfahren, wo sie das gewünschte Resultat liefern, im Hinblick auf eine kostengünstige (Massen-)Produktion vorzuziehen.

Alternativ zu einer einseitig eingebrachten Mikrostruktur kann sich die Strukturierung auch als gewelltes Profil des gesamten Blechabschnittes darstellen. Das heißt, dass auf beiden gegenüberliegenden Seiten des Blechabschnittes eine komplementäre Oberflächenstruktur ausgebildet ist. Als Umformverfahren kommt hierfür Tiefziehen, eine Kombination von Streck- und Tiefziehen oder Profilwalzen (Biegen) in Betracht.

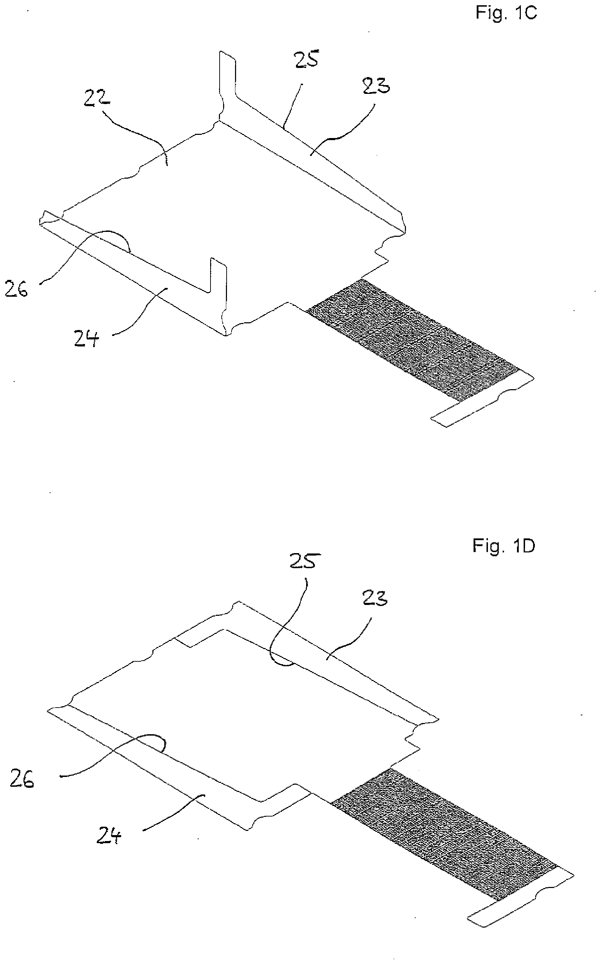

Im Folgenden wird anhand der Figuren 1C und 1D der Umformprozess beschrieben, bei dem das Blech entlang definierter Biegelinien (nicht eingezeichnet) in zwei Arbeitsschritten um jeweils 90° derart gefaltet wird, bis die dritten Abschnitte 23 und 24 flächenparallel auf dem unstrukturierten zweiten Abschnitt 22 aufliegen. Dieser Zustand ist in Figur 1D dargestellt. In diesem Zustand bilden sich entlang der konturierten Kanten 25 und 26 der dritten Abschnitte 23 bzw. 24 zu der unstrukturierten Oberfläche des ersten Abschnitts 22 Absätze aus.

In zwei weiteren darauffolgenden Arbeitsschritten wird das Blech entlang einer definierten Biegelinie (nicht gezeigt) derart um jeweils 90° gefaltet, bis der erste, strukturierte Abschnitt 21 des Bleches flächenparallel auf dem zweiten, unstrukturierten Abschnitt 22 des Bleches zu liegen kommt. Dieser Zustand ist in Figur 1F dargestellt. In diesem Zustand ist das mikrofluidische Bauteil fertig.

Nach wie vor hängen die ersten, zweiten und dritten Abschnitte einstückig zusammen. Die vor dem Falten offenen Mikrokanäle auf der zum Betrachter hin gewandten Oberfläche des ersten Abschnitts 21 bilden nach dem Falten auf der nun zu dem zweiten Abschnitt 22 hin gewandten Oberfläche zusammen mit der unstruktierten Oberfläche des zweiten Abschnitts 22 geschlossene Kanäle.

Die konturierten Kanten 25 und 26 der dritten Abschnitte 23 bzw. 24 bilden in dem gefalteten Zustand der Figur 1F erste Wandabschnitte, die im wesentlichen senkrecht auf der unstrukturierten Oberfläche des zweiten Abschnitts 22 stehen. Die unstrukturierte Oberfläche des zweiten Abschnitts 22 bildet selbst jeweils einen zweiten Wandabschnitt. Beide Wandabschnitte definieren eine offene Fluidleitung in Form von zwei durch den ersten Abschnitt 21 getrennte Vertiefungen 27 und 28.

Der erste Abschnitt 21 weist an seinem an den zweiten Abschnitt 22 angrenzenden Ende und an seinem dem Abschnitt 22 fernen Ende jeweils einen Vorsprung 29 bzw. 30 auf. Vorsprünge 31 bzw. 32 mit ähnlicher Geometrie weisen die beiden dritte Abschnitte 23 und 24 auf, welche jeweils einen Teil der konturierten Kante 25 bzw. 26 definieren. Auch die Vorsprünge 29 und 30 definieren konturierte Kanten im Sinne der Erfindung. Alle vier Vorsprünge begrenzen zusammen die Vertiefungen 27 bzw. 28 an deren längsseitigen Enden bis auf jeweils eine diagonal gegenüberliegende Öffnung 33 und 34, welche als Zu- bzw. Ablauf für ein Fluid dienen. Die Vertiefungen 27 und 28 bilden im Sinne dieser Schrift jeweils offene Fluidleitungen. Die Vertiefung 28 dient als Verteilerstruktur der Flussverteilung des Fluids, welches beispielsweise durch die Öffnung 34 (Zuleitung) in den Bereich der Vertiefung 28 gelangt, dort auf die in die Vertiefung 28 mündenden, geschlossenen Kanäle zwischen dem ersten Abschnitt 21 und dem zweiten Abschnitt 22 verteilt und durch diese Kanäle in die zweite offene Fluidleitung 27 transportiert wird. Die Vertiefung 27 dient also als Sammelstruktur zum Zusammenführen des Fluids aus den in die Vertiefung 27 mündenden, geschlossene Kanäle. Das gesammelte Fluid wird schließlich durch die Öffnung 33 (Ableitung) abgezogen.Die Pfeile deuten den Strömungsverlauf an. Die Verteilerstruktur 28 und die Sammelstruktur 27 unterscheiden sich nur in ihrer Funktion, bedingt durch die Anströmrichtung des Fluids. Strukturell sind sie identisch.

Die Figuren 1A bis 1F demonstrieren, dass die Erfindung dem Serienfertigungsanspruch dadurch gerecht wird, dass die einzelnen mikrostrukturierten Bauteile durch industriell etablierte Blechbearbeitungstechniken hergestellt werden können, wobei die Mikrostruktur des so erzeugten Bauteils nicht allein auf Mikrokanäle beschränkt bleiben muss sondern auch Mikrostrukturelemente, wie die exemplarisch gewählten Flussverteiler, umfassen kann.

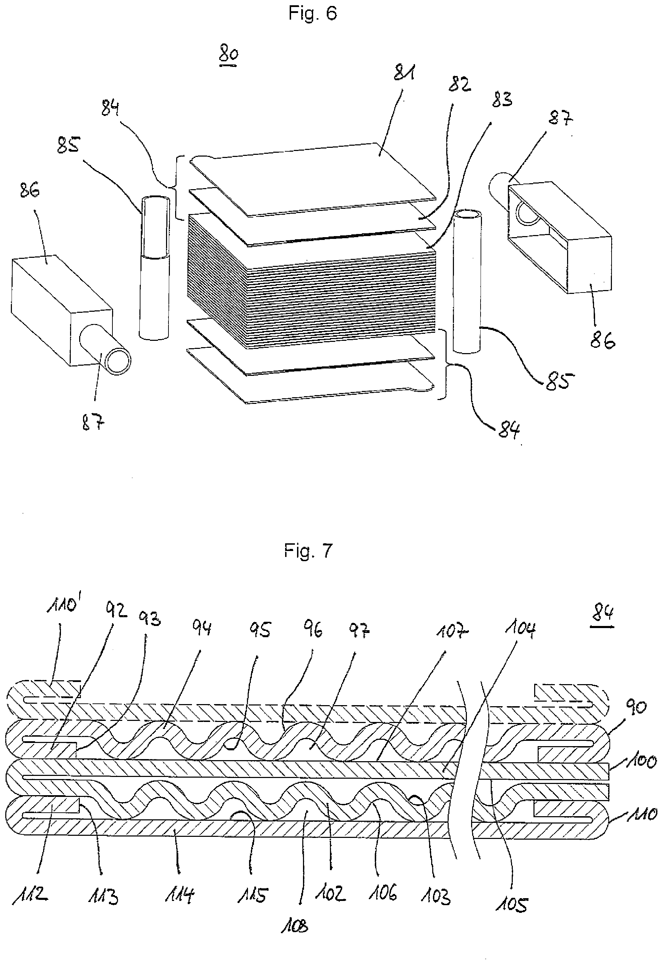

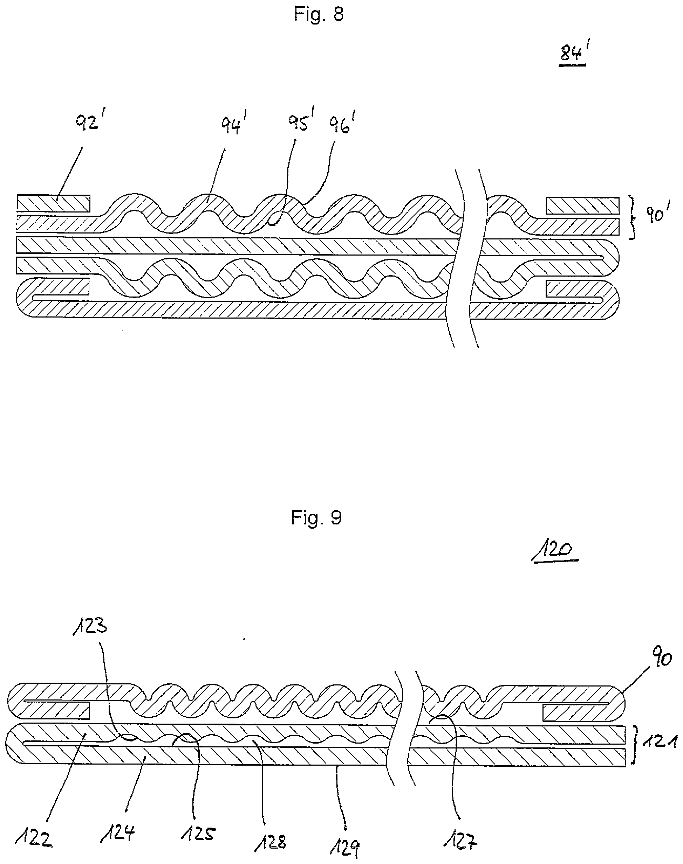

Das mikrofluidische Bauteil gemäß Figur 1F kann beispielsweise als Modul in mikrofluidischen Reaktoren im erweiterten Sinne verwendet werden. In solchen mikrofluidischen Reaktoren sind mehrere solcher Module mit gleicher oder unterschiedlicher Strukturierung und Funktion übereinander gestapelt. Dabei sind die angrenzenden Module jeweils so ausgebildet, dass jedes Bauteil mit einer offenen Fluidleitung durch die (strukturierte oder unstrukturierte) Oberfläche des angrenzenden benachbarten Bauteils verschlossen wird. Eigens zum Verschließen können mikrofluidische Bauteile im Sinne der Erfindung als Deckelelemente ausgebildet sein. Wie dies zu verstechen ist, wird weiter unten unter Bezugnahme auf die Figuren 7 und 8 erläutert.

Je nach Anwendungszweck des mikrofluidischen Reaktors ist bevorzugt die mikrostrukturierte Oberfläche des ersten Abschnitts 21 und/oder in seltenen Fällen die unstrukturierte Oberfläche des zweiten Abschnitts 22 des Moduls gemäß Figur 1F mit einem Katalysator beschichtet. Als Beschichtungsverfahren kommt vorzugsweise ein Siebdruckverfahren zum Einsatz.

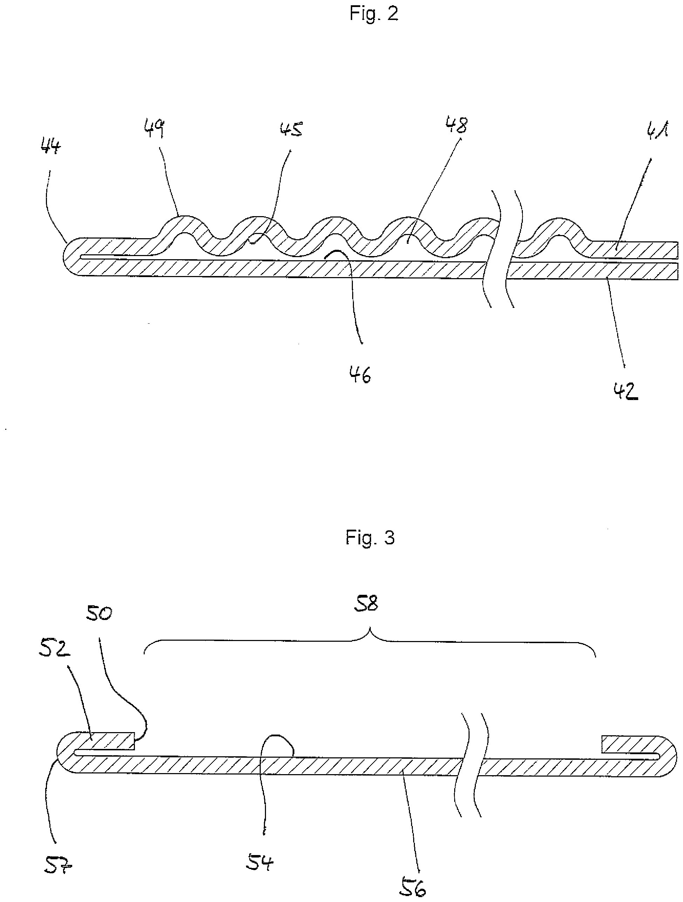

In den Figuren 2 bis 5 sind beispielhaft Ausschnitte vier verschiedener Kombinationen gefalteter Abschnitte gezeigt, welche mikrofluidische Bauteile kennzeichnen. Figur 2 zeigt den Ausschnitt eines mikrofluidischen Bauteils, bei dem das Blech einen ersten Abschnitt 41 mit strukturierter Oberfläche und einen zweiten Abschnitt 42 mit unstrukturierter Oberfläche aufweist. Das Blech ist entlang einer Faltkante 44 derart gefaltet, dass die beiden Abschnitte 41 und 42 einstückig zusammenhängend flächenparallel aufeinander aufliegen. Hierdurch bildet die strukturierte Oberfläche 45 auf der Unterseite des ersten Abschnitts 41 zusammen mit der unstrukturierten Oberfläche 46 auf der Oberseite des zweiten Abschnitts 42 geschlossene Fluidleitungen 48 aus. Der erste Abschnitt 41 ist wellenförmig strukturiert, so dass er auch auf seiner nach oben gewandten Oberfläche 49 Strukturelemente aufweist, die auch nach dem Falten offene Fluidleitungen bilden.

Das erfindungsgemäße Beispiel eines mikrofluidischen Bauteils, wie in Figur 3 gezeigt, besteht aus einem Blech mit einem eine konturierte Kante 50 aufweisenden Abschnitt 52 und einem eine unstrukturierte Oberfläche 54 aufweisenden Abschnitt 56. Das Blech ist entlang einer Biegekante 57 derart gefaltet, dass die einstückig zusammenhängenden Abschnitte 52 und 56 flächenparallel aufeinander aufliegen und die konturierte Kante 50 einen ersten Wandabschnitt und die angrenzende unstrukturierte Oberfläche 54 des Abschnitts 56 einen zweiten Wandabschnitt einer offenen Fluidleitung 58 bilden.

Das mikrofluidische Bauteil gemäß der Figuren 1A bis 1F vereint genau die beiden anhand der Figuren 2 und 3 erläuterten Aspekte der Erfindung.

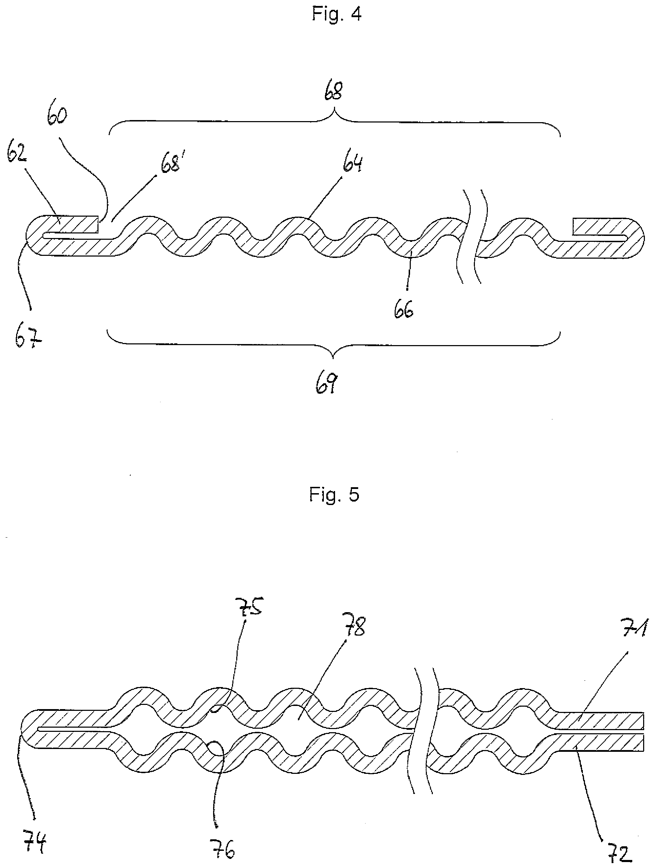

Das erfindungsgemäße Ausführungsbeispiel eines mikrofluidischen Bauteils nach Figur 4 ist analog dem gemäß Figur 3 aufgebaut. Es besteht aus einem Blech mit einem eine konturierte Kante 60 aufweisenden Abschnitt 62 und einem eine - insoweit abweichend von Figur 3 - strukturierte Oberfläche 64 aufweisenden Abschnitt 66. Die beiden Abschnitte 64 und 66 sind in analoger Weise entlang einer Biegekante 67 derart gefaltet, dass sie flächenparallel aufeinander aufliegen und die konturierte Kante 60 einen ersten Wandabschnitt und die angrenzende strukturierte Oberfläche 64 einen zweiten Wandabschnitt einer offenen Fluidleitung 68 bilden. Aufgrund der wellenförmigen Strukturierung bilden sich auf der Oberfläche 64 genau genommen mehrere offene Fluidleitungen aus, von denen nur die erste Fluidleitung 68' durch die konturierte Kante 60 begrenzt wird. Die Strukturierung des Abschnitts 66 ist wiederum wellenförmig ausgebildet, so dass die strukturierte Oberfläche auf der Unterseite des Abschnitts 66 ihrerseits offene Fluidleitungen 69 bereitstellt.

Das mikrofluidische Bauteil gemäß Figur 5 besteht aus einem Blech mit einem ersten Abschnitt 71 und einem zweiten Abschnitt 72, das entlang einer Biegekante 74 derart gefaltet ist, dass die einstückig zusammenhängenden Abschnitte 71 und 72 flächenparallel aufeinander aufliegen. Der erste Abschnitt 71 weist eine strukturierte Oberfläche 75 und der zweite Abschnitt 72 ebenfalls eine strukturierte Oberfläche 76 auf. Die strukturierten Oberflächen 75 und 76 grenzen nach dem Falten aneinander an und bilden geschlossene Fluidleitungen 78.

Es ist bei jeder der in den Figuren 2 bis 5 gezeigten Bauformen ersichtlich möglich beliebige Strukturelemente ind die Oberflächen zu prägen, wodurch eine Vielfalt an offenen oder geschlossenen Fluidleitungen erzeugt werden kann. Insbesondere sei vermerkt, dass die in den Figuren 2 bis 5 gezeigten strukturierten Abschnitte 1 und 2 jeweils wellenförmige Strukturen aufweisen, wie sie beispielsweise durch Biegen oder Tiefziehen eines Bleches erzeugt werden können, so dass sich die Strukturmerkmale auf beiden Oberflächen der Abschnitte komplementär zeigen. Dies ist jedoch nur eine Option. Wie bereits weiter oben ausgeführt, können die entsprechenden Abschnitte 1 und 2 beispielsweise auch einseitig eingeprägte Strukturen aufweisen. Ein Beispiel hierfür wird unter Bezugnahme auf Figur 8 erläutert.

Bei allen hier illustrierten Beispielen sind die dritten Abschnitte 23, 24 52 oder 62 senkrecht zur Biegekante relativ kurz und werden entlang einer relativ langen Biegekante gefaltet. Dies ist jedoch ersichtlich nicht zwingend. Das Schnitt- und das Faltmuster kann der Fachmann ganz nach den gestellten Anforderungen und im Hinbick auf einen materialsparenden Schnitt auswählen.

Figur 6 zeigt ein Ausführungsbeispiel des erfindungsgemäßen mikrofluidischen Reaktors in einer Explosionsdarstellung. Der mikrofluidische Reaktor 80 ist in diesem Beispiel ein sogenannter Plattenwärmetauscher-Reaktor. Er besteht in dem gezeigten Beispiel aus drei verschiedenen mikrofluidischen Bauteilen oder Module 81, 82, 83, die aufeinander gestapelt zu einem Reaktormodul 84 zusammengefasst sind. Mehrere der Reaktormodule 84 sind dann wiederum aufeinandergestapelt und entlang ihres Umfangs bis auf gezielte Öffnungen fluiddicht verschweißt. Zur Einleitung eines Fluids werden auf zwei entgegengesetzten Stirnseiten des Reaktorstapels über die Höhe des Reaktorstapels halbierte Rohre 85 angesetzt und verschweißt, welche vorzugsweise aus demselben Material gerfertigt sind, wie die mikrofluidischen Bauteile und bevorzugt aus Edelstahl bestehen. Entlang der hierzu senkrechten Stirnseiten des Reaktorstapels sind ist gegenüberliegenden Fluidverteilerkästen 86, vorzugsweise ebenfalls aus Edelstahl angesetzt und angeschweißt, welche jeweils einen Fluidein- bzw- Auslass 87 aufweisen.

Ein solches Reaktormodul 84 aus drei mikrofluidischen Bauteilen ist in Figur 7 im Schnitt dargestellt. Das Reaktormodul 84 besteht bei dieser Ausführungsform aus drei unterschiedlichen, übereinandergestapelten mikrofluidischen Bauteilen, nämlich einem Reformermodul 90, einem Brennermodul 100 und einem Deckelmodul 110. Diese Anordnung ist ausschnittsweise in Figur 7 gezeigt. Das Reformermodul 90 entspricht im Prinzip der in Figur 4 dargestellten Bauform und weist einen Abschnitt 92 mit einer konturierten Kante 93 sowie einen Abschnitt 94 mit einer strukturierten Oberfläche 95 auf. Wiederum erstreckt sich die Strukturierung wellenförmig durch das Blech des Bauteils hindurch, so dass die gegenüberliegende Oberfläche 96 des Abschnitts 94 eine Strukturierung komplementärer Art aufweist.

Das Brennermodul 100 entspricht entlang des hier dargestellten Schnittes der Bauform gemäß Figur 2 mit einem ersten Abschnitt 102, der eine strukturierte Oberfläche 103 aufweist, und einem zweiten Abschnitt 104, der eine unstrukturierte Oberfläche 105 aufweist. Der Abschnitt 102 ist wiederum wellenförmig strukturiert, so dass er auch auf der Außenseite des Brennermoduls 100 eine strukturierte Oberfläche 106 aufweist. Das Brennermodul 100 kann beispielsweise aufgebaut sein, wie das mikrofluidische Bauteil gemäß Figuren 1A bis 1F. Dann würde sich entlang eines zu dem hier dargestellten Schnitt senkrechten Schnittes zeigen, dass das Modul zugleich dritte Abschnitte mit konturierten Kanten aufweist, die offene Fluidverteiler definieren.

Das Deckelmodul 110 ist ein mikrofluidisches Bauteil gemäß der Bauform der Figur 3. Es weist einen Abschnitt 112 mit einer konturierten Kante 113 und eine Abschnitt 114 mit einer unstrukturierten Oberfläche 115 auf.

Die drei mikrofluidischen Bauteile sind dergestalt aufeinandergestapelt, dass die unstrukturierte Oberfläche 115 des Deckelmoduls 110 an die strukturierte Oberfläche 106 auf der Außenseite des Brennermoduls 100 angrenzt. Auf einer unstrukturierten Außenseite des zweiten Abschnitts 104 des Brennermoduls 100 schließt sich die strukturierte Oberfläche 95 des Abschnitts 94 des Reformermoduls 90 flächenparallel an.

In einem Stapel mehrerer solcher Reaktormodule 84 würde auf der Oberseite des Reformermoduls 90 sich das nächste Reaktormodul mit der unstrukturierten Unterseite seines Deckelmodul 110' anschließen, gestrichelt dargestellt.

Bei dieser Konfiguration bilden die durch die strukturierte innere Oberfläche 95 des Reformermoduls 90 ausgebildeten offenen Fluidleitungen zusammen mit der unstrukturierten äußeren Oberfläche 107 des zweiten Abschnitts 104 des Reaktormoduls 100 sowie auf der anderen Seite die durch die strukturierte äußere Oberfläche 96 des Reformermoduls 90 ausgebildeten offenen Fluidleitungen zusammen mit der unstrukturierten äußeren Oberfläche des nächsten Deckelmoduls 110' geschlossene Fluidleitungen 97 des Brennermoduls aus. Diese werden werden stirnseitig über die Fluidverteilerkästen 86 angeströmt.

Das Brennermodul 100 selbst bildet zunächst die besagten geschlossenen Fluidleitungen zwischen der strukturierten Oberfläche 104 und der unstrukturierten Oberfläche 105. Ferner bilden die durch die strukturierte Oberfläche 106 auf der Außenseite des ersten Abschnitts 102 des Brennermoduls 100 geformten, zunächst offenen Fluidleitungen 108 zusammen mit der unstrukturierten inneren Oberfläche 115 des Abschnitts 114 des Deckelmoduls 110 geschlossene Fluidleitungen 108. Auf diese Weise erhöht sich die Anzahl der geschlossene Kanäle des Brennermoduls. Damit alle Kanäle des Brennermoduls gut angeströmt werden, weist das Deckelmodul 110 vorzugsweise weitere, senkrecht zu der Darstellungsebene gefaltete Abschnitte mit konturierter Kante auf, die den korrespondierenden konturierten Kanten der dritte Abschnitte des Brennermoduls gemäß Figuren 1A bis 1F folgt. Auf diese Weise erstrecken sich die hier nicht zu sehenden Fluidverteiler lateral zu den Modulebenen über den gesamten Zwischenraum zwischen der inneren Oberfläche 105 des zweiten Abschnitts 104 des Brennermoduls 100 und der inneren Oberfläche 115 des Abschnittes 114 des Deckelmoduls 110.

In Figur 8 ist ein alternatives Ausführungsbeispiel eines mikrofluidischen Reaktormoduls 84' gezeigt, welches dem Reaktormodul 84 gemäß Figur 7 strukturell bis auf einen Unterschied entspricht: Das Reformermodul 90' weist einen Abschnitt 92' auf, dessen Biegekante nicht senkrecht zu der Darstellungsebene sondern parallel dazu verläuft. Dadurch erscheint der Abschnitt 92' in der Schnittdarstellung als unverbundenes Element, das nicht mit dem Abschnitt 94' mit strukturierter Oberfläche 95', 96' des Reformermoduls 90' zusammenhängt.

In Figur 9 ist ein alternatives Ausführungsbeispiel eines mikrofluidischen Reaktormoduls 120 gezeigt, welches dem Reaktormodul 84 funktional entspricht, aber nur aus zwei mikrofluidischen Bauteilen, nämlich einem Reformermodul 90 und einem Brennermodul 121 besteht. Das Reformermodul 90 entspricht in allen Einzelheiten dem Reformermodul 90 aus Figur 7, weshalb insoweit auf die vorstehende Beschreibung verwiesen wird. Auf ein Deckelmodul kann bei diesem Reaktormodul 120 allerdings verzichtet werden. Der Grund hierfür ist eine geänderte Bauform des Brennermoduls 121, welches aus einem ersten Abschnitt 122 mit einer strukturierten Oberfläche 123 und einem zweiten Abschnitt 124 mit einer unstrukturierten Oberfläche 125 besteht. Zwischen der strukturierten Oberfläche 123 des ersten Abschnitts 122 und der unstrukturierten Oberfläche 125 des zweiten Abschnitts 124 sind geschlossene Fluidleitungen 128 ausgebildet. Insoweit unterscheidet sich auch das Brennermodul 121 nicht von dem Brennermodul 100 der Figur 7. Der Unterschied besteht darin, dass die Oberflächenstruktur 123 einseitig in den ersten Abschnitt 122 des Bleches eingeprägt ist, so dass die gegenüberliegende Oberfläche 127 unstrukturiert ist. Hierdurch weist das gefaltete Blech des Brennermoduls 121 nach beiden Außenseiten unstrukturierte Oberflächen 127 bzw. 129 auf. Das Brennermodul 121 kann deshalb beliebig orientiert mit der einen oder anderen Oberfläche 127 oder 129 nach oben weisend an das Reformermodul 90 angrenzen und stellt in jedem Fall zugleich auf seiner Unterseite eine strukturlose Oberfläche 129 zum Anschluss an die strukturierte Oberfläche des Reformermoduls des nachfolgende Reaktormoduls bereit.

Die Profiltiefen der offenen bzw. geschlossenen Fluidleitungen sind gleich der Blechstärke der wellenförmig strukturierten Bleche. Dies ergibt sich aus dem Umstand, dass die Gesamtstärke eines profilierten Abschnittes, d. h. die Summe aus Profiltiefe und Blechstärke der zweifachen Blechstärke entsprechen muss, um eine entsprechende Profilierung durch ein einfach gefaltetes Blech mit doppelter Blechstärke kompensieren zu können, damit parallele Stapel gebildet werden können, vgl. Figuren 7 und 8. Aus den genannten Abmessungen der mikrofluidischen Strukturen ergibt sich, dass das Blech sehr dünn, also auch eine Folien von wenigen µm Dicke sein kann.

Auch wenn dies hier nicht anhand von Ausführungsbeispielen demonstriert ist, ist ersichtlich, dass auch mehrfach dergestalt gefaltete Blechabschnitte, dass mehrere Lagen eines einstückig zusammenhängenden Bleches flächenparallel aufeinanderliegen, zur Erfindung zu rechnen sind.

Die Breite der gebildeten offenen oder geschlossenen Fluidleitungen kann je nach Anwendung variieren. Im Fall von offenen oder geschlossenen Kanälen liegt die Breite im Bereich von 100 nm bis 1 mm und bevorzugt in der Größenordnung der Profiltiefen, d. h. zwischen 25 µm und 1 mm. Im Fall der taschenförmigen Fluidverteiler ist die laterale Abmessung beliebig wählbar und richtet sich nach den gewünschten/geforderten Strömungsverhältnissen.

### Bezugszeichenliste

- 10: Platine, Rohling
- 12: Konturlinie, Außenkontur

- 21: erster Blechabschnitt
- 22: zweiter Blechabschnitt
- 23, 24: dritter Blechabschnitt
- 25, 26: konturierte Kante
- 27: Vertiefung, offene Fluidleitung, Ableitung
- 28: Vertiefung, offene Fluidleitung, Zuleitung
- 29, 30, 31, 32: Vorsprung
- 33, 34: Öffnung, Zu- bzw. Ablauf

- 41: erster Abschnitt
- 42: zweiter Abschnitt
- 44: Biegekante
- 45: strukturierte Oberfläche des ersten Abschnitts
- 46: unstrukturierte Oberfläche des zweiten Abschnitts
- 48: geschlossene Fluidleitung, geschlossener Kanal

- 50: konturierte Kante
- 52: Abschnitt mit konturierter Kante
- 54: unstrukturierte Oberfläche
- 56: Abschnitt mit unstrukturierter Oberfläche
- 57: Biegekante
- 58: offene Fluidleitung

- 60: konturierte Kante
- 62: Abschnitt mit konturierter Kante
- 64: strukturierte Oberfläche
- 66: Abschnitt mit strukturierter Oberfläche
- 67: Biegekante
- 68: offene Fluidleitung
- 68': erste offene Fluidleitung
- 69: offene Fluidleitung auf der Außenseite

- 71: erster Abschnitt mit strukturierter Oberfläche
- 72: zweiter Abschnitt mit strukturierter Oberfläche
- 74: Biegekante
- 75: strukturierte Oberfläche
- 76: strukturierte Oberfläche
- 78: geschlossene Fluidleitungen, Kanäle

- 80: mikrofluidischer Reaktor
- 81: erstes mikrofluidisches Bauteil
- 82: zweites mikrofluidisches Bauteil
- 83: drittes mikrofluidisches Bauteil
- 84: Reaktormodul
- 85: rohrförmiger Fluidverteiler
- 86: kastenförmiger Fluidverteiler
- 87: Zu- bzw. Abführung

- 90, 90': Reformermodul, mikrofluidisches Bauteil
- 92, 92': erster Abschnitt
- 93: konturierte Kante
- 94, 94': zweiter Abschnitt
- 95, 95': strukturierte Oberfläche
- 96, 96': strukturierte Oberfläche
- 97: geschlossene Fluidleitung

- 100: Brennermodul, mikrofluidisches Bauteil
- 102: erster Abschnitt
- 103: strukturierte Oberfläche
- 104: zweiter Abschnitt
- 105: unstrukturierte Oberfläche
- 106: strukturierte Oberfläche auf der Außenseite
- 107: unstrukturierte Oberfläche auf der Außenseite
- 108: geschlossene Fluidleitung
- 110: Deckelmodul, mikrofluidisches Bauteil
- 112: Abschnitt mit konturierter Kante
- 113: konturierte Kante
- 114: unstrukturierter Abschnitt
- 115: unstrukturierte Oberfläche

- 120: Reaktormodul
- 121: Brennermodul, mikrofluidisches Bauteil
- 122: erster Abschnitt
- 123: strukturierte Oberfläche
- 124: zweiter Abschnitt
- 125: unstrukturierte Oberfläche
- 127: unstrukturierte Oberfläche des ersten Abschnitts
- 128: geschlossene Fluidleitung, Kanal
- 129: unstrukturierte Oberfläche des zweiten Abschnitts auf der Außenseite

## Patentansprüche

1. Mikrofluidisches Bauteil aus einem Blech, mit wenigstens einem eine wellenförmig strukturierte Oberfläche (45, 64) aufweisenden ersten und wahlweise einem eine wellenförmig strukturierte oder unstrukturierte Oberfläche aufweisenden zweiten Abschnitt (21, 22, 41, 42, 56, 66) und wenigstens einem eine konturierte Kante (25, 26, 50, 60) aufweisenden dritten Abschnitt (23, 24, 52, 62), das derart gefaltet ist, dass die einstückig zusammenhängenden ersten und dritten Abschnitte flächenparallel aufeinander liegen und die konturierte Kante (25, 26, 50, 60) einen ersten Wandabschnitt und die angrenzende wellenförmig strukturierte Oberfläche (45, 64) einen zweiten Wandabschnitt einer offenen Fluidleitung (27, 28, 58, 68, 68', 69) bilden, wobei als offenen Fluidleitung eine Fluidleitung verstanden wird, die abgesehen von etwaigen Zu- und/oder Abläufen zumindest einseitig offen ist und wobei die Profiltiefe der offenen Fluidleitung gleich der Blechstärke des Bleches ist.

2. Mikrofluidisches Bauteil aus einem Blech, mit einer eine geschlossene Fluidleitung (48, 78) umfassenden Struktur, nach Anspruch 1, wobei als geschlossene Fluidleitung eine bis auf etwaige Zu- und/oder Abläufe durch Wandabschnitte allseitig begrenzte Kavität verstanden wird, **dadurch gekennzeichnet, dass** die geschlossene Fluidleitung (48, 78) aus der wellenförmig strukturierten Oberfläche (45, 75) des ersten Abschnitts (21, 41, 71) des Bleches und der angrenzenden unstrukturierten Oberfläche (46) des zweiten Abschnitts (22, 42) des Bleches gebildet wird, wobei das Blech derart gefaltet ist, dass die einstückig zusammenhängenden ersten und zweiten Abschnitte flächenparallel aufeinander liegen, und wobei die Profiltiefe der geschlossenen Fluidleitung gleich der Blechstärke des Bleches ist.

3. Mikrofluidisches Bauteil nach Anspruch 1 oder 2,
**dadurch gekennzeichnet, dass** die strukturierte Oberfläche (45, 64, 75, 76) eine geprägte Oberfläche ist.

4. Mikrofluidisches Bauteil nach einem der Ansprüche 2 oder 3,
**dadurch gekennzeichnet, dass** die geschlossene Fluidleitung einen geschlossenen Kanal bildet, der in die offene Fluidleitung (27, 28) mündet.

5. Mikrofluidisches Bauteil nach Anspruch 4,
**dadurch gekennzeichnet, dass** die offene Fluidleitung (27, 28) eine Sammel- oder Verteilerstruktur zum Zusammenführen eines Fluids aus mehreren der geschlossenen Kanäle bzw. Verteilen des Fluids auf mehrere der geschlossenen Kanäle ist.

6. Mikrofluidisches Bauteil nach einem der Ansprüche 2 bis 5,
**dadurch gekennzeichnet, dass** die wellenförmig strukturierte Oberfläche (45, 75) des ersten Abschnitts (21, 41, 71) und/oder die wellenförmig strukturierte oder unstrukturierte Oberfläche (46, 76) des zweiten Abschnitts (22, 42, 72) wenigstens im Bereich der geschlossenen und/oder offenen Fluidleitung (27, 28, 48, 58, 68, 68', 69, 78) beschichtet ist.

7. Mikrofluidischer Reaktor (80),
**dadurch gekennzeichnet, dass** mehrere mikrofluidische Bauteile (81, 82, 83) nach einem der vorstehenden Ansprüche gestapelt und entlang ihres Umfangs bis auf gezielte Öffnungen fluiddicht verbunden sind.

8. Mikrofluidischer Reaktor (80) nach Anspruch 7,
**dadurch gekennzeichnet, dass** von den mehreren mikrofluidischen Bauteilen (81, 82, 83) wenigstens eines mit einer offenen Fluidleitung gemäß Anspruch 1 der Gestalt an ein benachbartes mikrofluidisches Bauteil angrenzt, dass die offene Fluidleitung und die wellenförmig strukturierte oder unstrukturierte Oberfläche (95, 96, 106) eines ersten oder zweiten Abschnitts des benachbarten Bauteils eine geschlossene Fluidleitung (97, 108) bilden.

9. Verfahren zur Herstellung eines mikrofluidischen Bauteils, bei dem ein Blech mit wenigstens einem eine wellenförmig strukturierte Oberfläche (45, 64) aufweisenden ersten und wahlweise einem eine wellenförmig strukturierte oder unstrukturierte Oberfläche aufweisenden zweiten Abschnitt (21, 22, 41, 42, 56, 66) und wenigstens einem eine konturierte Kante (25, 26, 50, 60) aufweisenden dritten Abschnitt (23, 24, 52, 62) derart gefaltet wird, dass der dritte Abschnitt mit der konturierten Kante flächenparallel auf dem ersten Abschnitt mit der wellenförmig strukturierte Oberfläche zu liegen kommt und die konturierte Kante einen ersten Wandabschnitt und die nach dem Falten daran angrenzende wellenförmig strukturierte Oberfläche einen zweiten Wandabschnitt einer offenen Fluidleitung (27, 28, 58, 68, 68', 69) bilden, wobei als offenen Fluidleitung eine Fluidleitung verstanden wird, die abgesehen von etwaigen Zu- und/oder Abläufen zumindest einseitig offen ist und wobei die Profiltiefe der offenen Fluidleitung gleich der Blechstärke des Bleches ist.

10. Verfahren zur Herstellung eines mikrofluidischen Bauteils nach Anspruch 9, bei dem das Blech mit dem wenigstens einen eine wellenförmig strukturierte Oberfläche (45, 75) aufweisenden ersten Abschnitt (21, 41, 71) und dem wenigstens einen eine unstrukturierte Oberfläche (46) aufweisenden zweiten Abschnitt (22, 42) derart gefaltet wird, dass der erste Abschnitt flächenparallel auf dem zweiten Abschnitt zu liegen kommt und die wellenförmig strukturierte Oberfläche des ersten Abschnitts zusammen mit der nach dem Falten daran angrenzenden unstrukturierten Oberfläche des zweiten Abschnitts eine geschlossenen Fluidleitung (48, 78) bilden, wobei als geschlossene Fluidleitung eine bis auf etwaige Zu- und/oder Abläufe durch Wandabschnitte allseitig begrenzte Kavität verstanden wird und wobei die Profiltiefe der geschlossenen Fluidleitung gleich der Blechstärke des Bleches ist.

11. Verfahren nach Anspruch 9 oder 10,
**dadurch gekennzeichnet, dass** die wellenförmig strukturierte Oberfläche (64, 75, 76) in einem dem Falten vorgeschalteten Prägeschritt hergestellt wird.

12. Verfahren nach Anspruch 11,
**dadurch gekennzeichnet, dass** das Prägen und Falten nacheinander in einem Folgeverbundwerkzeug erfolgt.

13. Verfahren nach Anspruch 9,
**dadurch gekennzeichnet, dass** die konturierte Kante (25, 26, 50, 60) in einem dem Falten vorgeschalteten Stanzschritt hergestellt wird.

14. Verfahren nach einem der Ansprüche 10 bis 13,
**dadurch gekennzeichnet, dass** die wellenförmig strukturierte Oberfläche (45, 75) des ersten Abschnitts (21, 41, 71) und/oder die wellenförmig strukturierte oder unstrukturierte Oberfläche (46, 76) des zweiten Abschnitts (22, 42, 72) wenigstens im Bereich der geschlossenen und/oder offenen Fluidleitung (27, 28, 48, 58, 68, 68', 69, 78) beschichtet wird.

15. Verfahren zur Herstellung eines mikrofluidischen Reaktors (80), bei dem mehrere mikrofluidische Bauteile (81, 82, 83) nach einem der Ansprüche 9 bis 14 hergestellt werden,
**dadurch gekennzeichnet, dass** die mehreren mikrofluidischen Bauteile (81, 82, 83) nach dem Falten übereinander geschichtet und entlang ihres Umfangs bis auf gezielte Öffnungen fluiddicht verschweißt werden.

16. Verfahren nach Anspruch 15,
**dadurch gekennzeichnet, dass** von den mehreren mikrofluidischen Bauteilen (81, 82, 83) wenigstens eines eine offenen Fluidleitung gemäß Anspruch 11 bildet, die beim Übereinanderschichten von der wellenförmig strukturierte oder unstrukturierten Oberfläche (95, 96, 106) eines Abschnitts eines benachbarten Bauteils geschlossenen wird.

## Claims

1. Microfluidic component comprising a metal sheet, having at least a first portion which has an undulatingly structured surface (45, 64) and optionally a second portion (21, 22, 41, 42, 56, 66) which has an undulatingly structured or unstructured surface and at least a third portion (23, 24, 52, 62) which has a contoured edge (25, 26, 50, 60) which is folded in such a manner that the integrally coherent first and third portions are positioned on each other in a surface-parallel manner and the contoured edge (25, 26, 50, 60) forms a first wall portion and the adjacent undulatingly structured surface (45, 64) forms a second wall portion of an open fluid line (27, 28, 58, 68, 68', 69), wherein an open fluid line is intended to be understood to be a fluid line which, with the exception of any inlets and/or outlets, is open at least at one side and wherein the profile depth of the open fluid line is equal to the thickness of the metal sheet.

2. Microfluidic component comprising a metal sheet having a structure which comprises a closed fluid line (48, 78) according to claim 1, wherein a closed fluid line is intended to be understood to be a cavity which with the exception of any inlets and/or outlets is delimited at all sides by wall portions,
**characterised in that** the closed fluid line (48, 78) is formed from the undulatingly structured surface (45, 75) of the first portion (21, 41, 71) of the metal sheet and the adjacent unstructured surface (46) of the second portion (22, 42) of the metal sheet, wherein the metal sheet is folded in such a manner that the integrally coherent first and second portions are positioned on each other in a surface-parallel manner and wherein the profile depth of the closed fluid line is equal to the thickness of the metal sheet.

3. Microfluidic component according to claim 1 or 2,
**characterised in that** the structured surface (45, 64, 75, 76) is a stamped surface.

4. Microfluidic component according to either claim 2 or claim 3, **characterised in that** the closed fluid line forms a closed channel which opens in the open fluid line (27, 28).

5. Microfluidic component according to claim 4,
**characterised in that** the open fluid line (27, 28) is a collection or distribution structure for combining a fluid from several of the closed channels or distributing the fluid over several of the closed channels.

6. Microfluidic component according to any one of claims 2 to 5,
**characterised in that** the undulatingly structured surface (45, 75) of the first portion (21, 41, 71) and/or the undulatingly structured or unstructured surface (46, 76) of the second portion (22, 42, 72) is/are coated at least in the region of the closed and/or open fluid line (27, 28, 48, 58, 68, 68', 69, 78) .

7. Microfluidic reactor (80),
**characterised in that** a plurality of microfluidic components (81, 82, 83) according to any one of the preceding claims are stacked and connected in a fluid-tight manner along the periphery thereof with the exception of selected openings.

8. Microfluidic reactor (80) according to claim 7,
**characterised in that** from the plurality of microfluidic components (81, 82, 83) at least one with an open fluid line according to claim 1 adjoins an adjacent microfluidic component in such a manner that the open fluid line and the undulatingly structured or unstructured surface (95, 96, 106) of a first or second portion of the adjacent component form a closed fluid line (97, 108).

9. Method for producing a microfluidic component, wherein a metal sheet having at least a first portion which has an undulatingly structured surface (45, 64) and optionally a second portion (21, 22, 41, 42, 56, 66) which has an undulatingly structured or unstructured surface and at least a third portion (23, 24, 52, 62) which has a contoured edge (25, 26, 50, 60) is folded in such a manner that the third portion with the contoured edge comes to rest in a surface-parallel manner on the first portion with the undulatingly structured surface and the contoured edge forms a first wall portion and the undulatingly structured surface which is adjacent thereto after the folding forms a second wall portion of an open fluid line (27, 28, 58, 68, 68', 69), wherein an open fluid line is intended to be understood to be a fluid line which with the exception of any inlets and/or outlets is open at least at one side and wherein the profile depth of the open fluid line is equal to the thickness of the metal sheet.

10. Method for producing a microfluidic component according to claim 9, wherein the metal sheet having the at least one first portion (21, 41, 71) which has an undulatingly structured surface (45, 75) and the at least one second portion (22, 42) which has an unstructured surface (46) is folded in such a manner that the first portion comes to rest in a surface-parallel manner on the second portion and the undulatingly structured surface of the first portion together with the unstructured surface of the second portion which is adjacent thereto after the folding form a closed fluid line (48, 78), wherein a closed fluid line is intended to be understood to be a cavity which with the exception of any inlets and/or outlets is delimited by wall portions at all sides and wherein the profile depth of the closed fluid line is equal to the thickness of the metal sheet.

11. Method according to claim 9 or 10,
**characterised in that** the undulatingly structured surface (64, 75, 76) is produced in a stamping step upstream of the folding.

12. Method according to claim 11,
**characterised in that** the stamping and folding are carried out one after the other in a progressive tool.

13. Method according to claim 9,
**characterised in that** the contoured edge (25, 26, 50, 60) is produced in a punching step upstream of the folding.

14. Method according to any one of claims 10 to 13,
**characterised in that** the undulatingly structured surface (45, 75) of the first portion (21, 41, 71) and/or the undulatingly structured or unstructured surface (46, 76) of the second portion (22, 42, 72) is/are coated at least in the region of the closed and/or open fluid line (27, 28, 48, 58, 68, 68', 69, 78) .

15. Method for producing a microfluidic reactor (80), wherein a plurality of microfluidic components (81, 82, 83) according to any one of claims 9 to 14 are produced,
**characterised in that** the plurality of microfluidic components (81, 82, 83) after the folding are layered one over the other and welded in a fluid-tight manner along the periphery thereof with the exception of selected openings.

16. Method according to claim 15,
**characterised in that** of the plurality of microfluidic components (81, 82, 83) at least one forms an open fluid line according to claim 11 which is closed when the undulatingly structured or unstructured surface (95, 96, 106) of a portion of an adjacent component is layered one over the other.

## Revendications

1. Élément microfluidique en une tôle, avec au moins une première section présentant une surface (45, 64) structurée ondulée et au choix une deuxième section (21, 22, 41, 42, 56, 66) présentant une surface structurée ondulée ou non structurée et au moins une troisième section (23, 24, 52, 62) présentant une arête profilée (25, 26, 50, 60), qui est pliée de sorte que les première et troisième sections cohérentes d'un seul tenant sont superposées parallèlement et l'arête profilée (25, 26, 50, 60) forme une première section de paroi et la surface (45, 64) structurée ondulée adjacente forme une deuxième section de paroi d'une conduite de fluide (27, 28, 58, 68, 68', 69) ouverte,
dans lequel une conduite de fluide, qui exception faite d'éventuelles amenées et/ou évacuations est ouverte au moins d'un côté, est considérée comme conduite de fluide ouverte et dans lequel la profondeur de profil de la conduite de fluide ouverte est égale à l'épaisseur de tôle de la tôle.

2. Élément microfluidique en une tôle, avec une structure comprenant une conduite de fluide fermée (48, 78), selon la revendication 1, dans lequel une cavité limitée de tous les côtés par des sections de paroi à l'exception d'éventuelles amenées et/ou évacuations est considérée comme conduite de fluide fermée,
**caractérisé en ce que** la conduite de fluide fermée (48, 78) est formée de la surface (45, 75) structurée ondulée de la première section (21, 41, 71) de la tôle et de la structure non structurée adjacente (46) de la deuxième section (22, 42) de la tôle, dans lequel la tôle est pliée de sorte que les première et deuxième sections cohérentes d'un seul tenant sont superposées parallèlement, et dans lequel la profondeur de profil de la conduite de fluide fermée est égale à l'épaisseur de tôle de la tôle.

3. Élément microfluidique selon la revendication 1 ou 2,
**caractérisé en ce que** la surface (45, 64, 75, 76) structurée est une surface gaufrée.

4. Élément microfluidique selon l'une quelconque des revendications 2 ou 3,
**caractérisé en ce que** la conduite de fluide fermée forme un canal fermé, qui débouche dans la conduite de fluide (27, 28) ouverte.

5. Élément microfluidique selon la revendication 4,
**caractérisé en ce que** la conduite de fluide (27, 28) ouverte est une structure de collecte ou de distribution pour le regroupement d'un fluide à partir de plusieurs des canaux fermés ou pour la distribution du fluide sur plusieurs des canaux fermés.

6. Élément microfluidique selon l'une quelconque des revendications 2 à 5,
**caractérisé en ce que** la surface (45, 75) structurée ondulée de la première section (21, 41, 71) et/ou la surface (46, 76) structurée ondulée ou non structurée de la deuxième section (22, 42, 72) est revêtue au moins dans la zone de la conduite de fluide (27, 28, 48, 58, 68, 68', 69, 78) fermée et/ou ouverte.

7. Réacteur microfluidique (80),
**caractérisé en ce que** plusieurs éléments microfluidiques (81, 82, 83) selon l'une quelconque des revendications précédentes sont empilés et reliés de manière étanche aux fluides le long de leur périphérie à l'exception d'ouvertures ciblées.

8. Réacteur microfluidique (80) selon la revendication 7,
**caractérisé en ce que** des plusieurs éléments microfluidiques (81, 82, 83) au moins un avec une conduite de fluide ouverte selon la revendication 1 est adjacent à un élément microfluidique adjacent de sorte que la conduite de fluide ouverte et la surface (95, 96, 106) structurée ondulée ou non structurée d'une première ou deuxième section de l'élément voisin forment une conduite de fluide fermée (97, 108).

9. Procédé de fabrication d'un élément microfluidique, dans lequel une tôle avec au moins une première section présentant une surface (45, 64) structurée ondulée et au choix une deuxième section (21, 22, 41, 42, 56, 66) présentant une surface structurée ondulée ou non structurée et au moins une troisième section (23, 24, 52, 62) présentant une arête profilée (25, 26, 50, 60) est pliée de sorte que la troisième section avec l'arête profilée repose parallèlement sur la première section avec la surface structurée ondulée et l'arête profilée forme une première section de paroi et la surface structurée ondulée adjacente à celle-ci après le pliage forme une deuxième section de paroi d'une conduite de fluide (27, 28, 58, 68, 68', 69) ouverte, dans lequel une conduite de fluide, qui exception faite d'éventuelles amenées et/ou évacuations est ouverte au moins d'un côté, est considérée comme conduite de fluide ouverte et dans lequel la profondeur de profil de la conduite de fluide ouverte est égale à l'épaisseur de tôle de la tôle.

10. Procédé de fabrication d'un élément microfluidique selon la revendication 9, dans lequel la tôle avec l'au moins une première section (21, 41, 71) présentant une surface (45, 75) structurée ondulée et l'au moins une deuxième section (22, 42) présentant une surface non structurée (46) est pliée de sorte que la première section repose parallèlement sur la deuxième section et la surface structurée ondulée de la première section conjointement avec la surface non structurée adjacente à celle-ci après le pliage de la deuxième section forment une conduite de fluide fermée (48, 78), dans lequel une cavité limitée de tous les côtés par des sections de paroi à l'exception d'éventuelles amenées et/ou évacuations est considérée comme conduite de fluide fermée et dans lequel la profondeur de profil de la conduite de fluide fermée est égale à l'épaisseur de tôle de la tôle.

11. Procédé selon la revendication 9 ou 10,
**caractérisé en ce que** la surface (64, 75, 76) structurée ondulée est fabriquée dans une étape de gaufrage en amont du pliage.

12. Procédé selon la revendication 11,
**caractérisé en ce que** le gaufrage et le pliage ont lieu l'un après l'autre dans un outil à suivre.

13. Procédé selon la revendication 9,
**caractérisé en ce que** l'arête profilée (25, 26, 50, 60) est fabriquée dans une étape d'estampage en amont du pliage.

14. Procédé selon l'une quelconque des revendications 10 à 13,
**caractérisé en ce que** la surface (45, 75) structurée ondulée de la première section (21, 41, 71) et/ou la surface (46, 76) structurée ondulée ou non structurée de la deuxième section (22, 42, 72) est revêtue au moins dans la zone de la conduite de fluide (27, 28, 48, 58, 68, 68', 69, 78) ouverte et/ou fermée.

15. Procédé de fabrication d'un réacteur microfluidique (80), dans lequel plusieurs éléments microfluidiques (81, 82, 83) selon l'une quelconque des revendications 9 à 14 sont fabriqués,
**caractérisé en ce que** les plusieurs éléments microfluidiques (81, 82, 83) sont disposés en couches les uns sur les autres après le pliage et soudés de manière étanche aux fluides le long de leur périphérie à l'exception d'ouvertures ciblées.

16. Procédé selon la revendication 15,
**caractérisé en ce que** des plusieurs éléments microfluidiques (81, 82, 83) au moins un forme une conduite fluidique ouverte selon la revendication 11, qui est fermée lors de la superposition de la surface (95, 96, 106) structurée ondulée ou non structurée d'une section d'un élément voisin.
